Europäisches Patentamt

(19) European Patent Office

Office européen des brevets

(11) Numéro de publication : **0 195 705**
**B1**

(12) **FASCICULE DE BREVET EUROPÉEN**

(45) Date de publication du fascicule du brevet :
02.11.89

(51) Int. Cl.⁴ : **H 03 K 19/007**

(21) Numéro de dépôt : 86400441.1

(22) Date de dépôt : 04.03.86

(54) **Circuit logique engendrant un courant continu d'intensité maximale déterminée en sortie.**

(30) Priorité : 13.03.85 FR 8503645

(43) Date de publication de la demande :
24.09.86 Bulletin 86/39

(45) Mention de la délivrance du brevet :
02.11.89 Bulletin 89/44

(84) Etats contractants désignés :
BE CH DE FR GB IT LI LU NL

(56) Documents cités :
PATENTS ABSTRACTS OF JAPAN, vol. 4, no. 133 (E-26) [615], 18 septembre 1980, page 25 E 26; & JP - A - 55 85 142 (YOSHIAKI KOGA) 26-06-1980

(73) Titulaire : JEUMONT-SCHNEIDER Société anonyme dite:
31-32, Quai de Dion Bouton
F-92811 Puteaux Cedex (FR)

(72) Inventeur : Guillaumin, Jacques
19, rue Jean Moulin
F-93260 Les Lilas (FR)

(74) Mandataire : Weinmiller, Jürgen et al
Lennéstrasse 9 Postfach 24
D-8133 Feldafing (DE)

## Description

La présente invention concerne un circuit logique déterminant un courant continu d'intensité maximale déterminée sur sa borne de sortie lorsqu'un signal alternatif d'amplitude quelconque est appliqué à sa borne d'entrée.

Un tel circuit logique trouve son application notamment dans le domaine de la signalisation ferroviaire et est, de préférence, disposé à l'entrée d'un autre circuit logique à seuil et à sécurité intrinsèque tel que décrit dans la demande de brevet français 83.16331 déposée le 13 octobre 1983 au nom de la déposante, et permettant de réaliser des fonctions logiques au moyen d'une pluralité de tels circuits ayant chacun la fonction « OUI ».

Dans ce type de circuit, on constate qu'il y a bien sûr un seuil minimum pour l'amplitude du signal d'entrée au-dessous duquel ce signal est considéré ne pas exister. Mais il existe également un seuil maximum pour cette même amplitude, seuil déterminé par la saturation permanente du transistor d'entrée. La fenêtre entre les deux seuils est relativement étroite. Cette caractéristique peut être avantageusement exploitée dans certaines applications, mais peut constituer un grave inconvénient dans d'autres applications.

La présente invention a donc pour but d'obvier à ce dernier inconvénient. Elle a pour objet un circuit logique tel qu'un courant continu apparaisse sur sa borne de sortie, courant présentant une intensité maximale déterminée, même si l'amplitude du signal d'entrée croît jusqu'à une valeur importante.

On détermine cette intensité maximale en connaissant l'impédance d'entrée du circuit logique à seuil auquel ce circuit est connecté, et les caractéristiques des deux seuils précités.

Le circuit logique engendrant un courant continu d'intensité maximale déterminée sur sa borne de sortie lorsqu'un signal alternatif d'amplitude quelconque est appliqué à sa borne d'entrée, comprend, selon l'invention, un convertisseur non référencé en tension continue par rapport à la masse, un condensateur connecté entre la borne de sortie positive et la borne de sortie négative du convertisseur, un générateur de courant constant connecté entre la borne de sortie positive et la masse, la borne de sortie négative constituant la borne de sortie du circuit logique.

De préférence, le convertisseur est constitué par des première et seconde diodes disposées en série, le signal alternatif d'entrée étant appliqué par l'intermédiaire d'un condensateur de liaison entre l'anode de la première diode dont la cathode constitue la borne de sortie positive du convertisseur, et la cathode de la seconde diode dont l'anode qui est reliée à la masse par l'intermédiaire d'un condensateur de découplage, constitue la borne de sortie négative du convertisseur.

De préférence, le générateur de courant est constitué par un transistor dont la base est reliée à la masse, le collecteur à la borne de sortie positive du convertisseur et l'émetteur à une source de tension négative par l'intermédiaire d'une résistance.

L'invention sera mieux comprise et d'autres buts, avantages et caractéristiques de celle-ci apparaîtront plus clairement à la lecture de la description qui suit d'un mode de réalisation donné à titre d'exemple non limitatif et à laquelle une planche de dessins est annexée, sur laquelle :

— la Figure 1 représente le schéma électrique de principe du circuit logique conforme à l'invention, et

— la Figure 2 représente le schéma électrique d'un mode préféré de réalisation de l'invention.

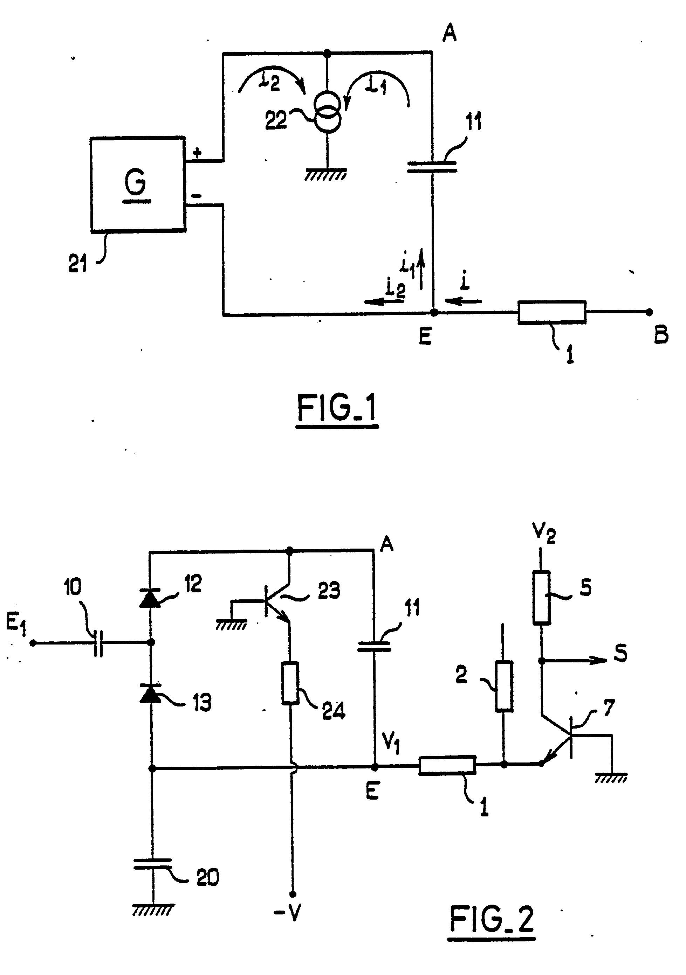

En référence maintenant à la Figure 1, on constate qu'une source de tension continue 21 charge un condensateur 11 connecté entre ses bornes de sortie. Un générateur de courant 22 est disposé entre la borne positive du générateur 21 et la masse. La borne négative du générateur 21 constitue la borne de sortie du circuit qui est relié à un autre circuit logique, tel que celui décrit dans la demande de brevet français précitée, ayant une résistance d'entrée 1. On constate donc aisément que, quelle que soit la différence de potentiel entre les bornes de sortie de la source de tension, si le condensateur 11 est chargé, le générateur de courant 22 impose l'intensité du courant i circulant dans le circuit et, par suite, la valeur de la tension aux bornes de la résistance d'entrée 1 du circuit logique suivant, dès lors qu'une tension appropriée est appliquée au point B. De ce fait, il n'y a pas de limite supérieure théorique à la charge du condensateur 11, c'est-à-dire à la différence de potentiel entre les bornes de la source de tension continue 21. Ainsi, en disposant un convertisseur à la place de la source de tension 21, convertisseur à l'entrée duquel on applique un signal alternatif d'amplitude suffisante quelconque et à la sortie duquel on trouve une tension continue, fonction de l'amplitude du signal d'entrée, on obtient un circuit logique tel, que la tension aux bornes de la résistance 1 présente une limite supérieure déterminée indépendamment de l'amplitude du signal d'entrée.

Un mode de réalisation est représenté Figure 2, dans lequel le convertisseur est constitué par une pompe à diodes, non référencée, en tension continue par rapport à la masse, et le générateur de courant constitué par un transistor monté en base commune. Le signal d'entrée alternatif est appliqué à la borne d'entrée E1, du circuit qui est relié au point de jonction des deux diodes 12 et 13 par l'intermédiaire d'un condensateur de liaison 10. Un condensateur de découplage 20 est prévu pour isoler le circuit en continu et le fermer en alternatif. Une différence de potentiel apparaît donc entre les bornes du condensateur 11, sans que la tension entre chaque borne soit fixée. De ce fait, la tension par rapport à la masse de chacune des bornes du condensateur 11 peut largement varier en fonction de l'amplitude du signal alternatif appliqué à la borne d'entrée E1. Le courant dans la résistance 1, fonction de la différence de potentiel entre ses bornes, est totalement déterminé par la tension négative continue appliquée à l'émetteur du transistor 23 par l'intermédiaire de la résistance 24, et par la valeur de cette résistance 24.

En effet, le transistor 23 est monté en base commune, sa base étant reliée à la masse, et présente un gain en courant sensiblement égal à l'unité. Son collecteur se comporte alors en générateur de courant dès lors que la tension au point A est positive. Le convertisseur de tension et le condensateur 11 étant isolés en continu par rapport à la masse, le courant ne peut venir que de la résistance 1 d'entrée du deuxième circuit logique dont on a représenté les premiers composants et tel que décrit dans la demande de brevet précitée.

Ainsi, il suffit que le condensateur 11 soit chargé au moins à la tension de seuil inférieur pour que la sortie S du deuxième circuit logique soit active. Mais il n'y a aucune limite supérieure à la charge du condensateur 11, donc à la valeur de l'amplitude du signal d'entrée.

On a ainsi réalisé un circuit logique ne présentant pas de valeur de seuil supérieur et pouvant être connecté à un circuit logique présentant un tel seuil supérieur. Un tel circuit conforme à la présente invention trouve également son application pour réaliser un temporisateur à la chute. En effet, le condensateur 11 sert de réserve pour le courant tiré par le collecteur du transistor 23 lorsque l'amplitude du signal alternatif appliqué à la borne d'entrée E1 s'annule. Le condensateur se décharge alors à courant constant, de sa tension de charge maximale jusqu'à la tension de seuil inférieur du deuxième circuit logique. Cette décharge prend un temps déterminé qui correspond à une temporisation à la chute. Ce circuit présente donc l'avantage supplémentaire d'assurer une temporisation à courant constant, c'est-à-dire dans les meilleures conditions de fonctionnement du circuit associé.

Bien que seul un mode de réalisation de l'invention ait été décrit, il est évident que toute modification apportée par l'Homme de l'Art ne sortirait pas du cadre de la présente invention telle que définie par les revendications annexées.

## Revendications

1. Circuit logique engendrant un courant continu d'intensité maximale déterminée sur sa borne de sortie (E) lorsqu'un signal alternatif d'amplitude quelconque est appliqué à sa borne d'entrée (E1), caractérisé en ce qu'il comprend un convertisseur (21) non référencé en tension continue par rapport à la masse, un condensateur (11) connecté entre la borne de sortie positive et la borne de sortie négative dudit convertisseur, un générateur de courant constant (22) connecté entre ladite borne de sortie positive et la masse, ladite borne de sortie négative constituant la borne de sortie dudit circuit logique.

2. Circuit logique selon la revendication 1, caractérisé en ce que ledit convertisseur est constitué par des première et seconde diodes (12, 13) disposées en série, ledit signal alternatif étant appliqué par l'intermédiaire d'un condensateur de liaison (10) entre l'anode de ladite première diode (12) dont la cathode constitue ladite borne de sortie positive, et la cathode de ladite seconde diode (13) dont l'anode qui est reliée à la masse par l'intermédiaire d'un condensateur de découplage (20), constitue ladite borne de sortie négative.

3. Circuit logique selon l'une quelconque des revendications 1 ou 2, caractérisé en ce que ledit générateur de courant constant est constitué par un transistor (23) dont la base est reliée à la masse, le collecteur à ladite borne de sortie positive et l'émetteur à une source de tension négative par l'intermédiaire d'une résistance (24).

## Claims

1. A logic circuit adapted to generate a direct current of predetermined maximum intensity at its output terminal (E) when an alternating signal of any amplitude is applied to its input terminal (E1), characterized in that it comprises a converter (21), isolated from earth for direct voltage, a capacitor (11) connected between the positive output terminal and the negative output terminal of said converter, and a constant current generator (22) connected between said positive output terminal and earth, said negative output terminal forming the output terminal of said logic circuit.

2. A logic circuit according to claim 1, characterized in that said converter is formed by first and second diodes (12, 13) arranged in series, said alternating signal being applied through a series-connected capacitor (10) between the anode of said first diode (12) whose cathode forms said positive output terminal, and the cathode of said second diode (13) whose anode, which is connected to earth through a decoupling capacitor (20), forms the negative output terminal.

3. A logic circuit according to any one of claims 1 or 2, characterized in that said constant current generator is formed by a transistor (23), whose base is connected to earth, whose collector is connected to said positive output terminal and whose emitter is connected to a negative voltage source through a resistor (24).

## Patentansprüche

1. Logische Schaltung zur Erzeugung eines Gleichstroms bestimmter maximaler Stärke an ihrer Ausgangsklemme (E), wenn ein alternierendes Signal beliebiger Amplitude an seine Eingangsklemme (E1) gelegt wird, dadurch gekennzeichnet, daß sie einen gleichspannungsmäßig erdfreien Wandler (21), einen zwischen die positive und die negative Ausgangsklemme des Wandlers geschalteten Kondensator (11) und einen Konstantstromgenerator (22) aufweist, der zwischen die positive Ausgangsklemme und Erde geschaltet ist, wobei die negative Ausgangsklemme die Ausgangsklemme der logischen Schaltung bildet.

2. Logische Schaltung nach Anspruch 1, dadurch gekennzeichnet, daß der Wandler aus einer ersten und einer zweiten Diode (12, 13), die in Reihe geschaltet sind, besteht und das alternierende Signal über einen Koppelkondensator (10) an den Verbindungspunkt zwischen der Anode der ersten Diode (12), deren Kathode die positive Ausgangsklemme bildet, und der Kathode der zweiten Diode (13), deren Anode über einen Entkopplungskondensator (20) an Erde geschaltet ist und die negative Ausgangsklemme bildet.

3. Logische Schaltung nach einem beliebigen der Ansprüche 1 oder 2, dadurch gekennzeichnet, daß der Konstantstromgenerator aus einem Transistor (23) besteht, dessen Basis an Erde, dessen Kollektor an die positive Ausgangsklemme und dessen Emitter über einen Widerstand (24) an ein negatives Spannungspotential angeschlossen ist.

FIG.1

FIG.2